# EUROPEAN PATENT APPLICATION

(11) **EP 3 945 609 A1**
(43) Date of publication of application: **02.02.2022**
(21) Application number: 20315374.7
(22) Date of filing: 31.07.2020
(51) Int. Cl.: H01L 43/08, H01L 43/10

(54) **MAGNETO RESISTIVE MEMORY DEVICE**

(71) Applicant: Antaios, 38240 Meylan (FR)
(72) Inventor: DROUARD, Marc, 26000 VALENCE (FR); MARTIN, Sylvain, 38100 GRENOBLE (FR); KULA, Witold, GILROY CA 95020 (US)
(74) Representative: IP Trust

(57) **Abstract**

The invention relates to a magneto resistive memory cell (1) comprising a SOT current layer (3) defining a main plane and a magnetic free layer (2) disposed on the SOT current layer (3), the magnetization direction (M) of the free layer (2) defining a state of the memory cell (1). According to the invention the free layer (2) comprises a first layer (2a) made of insulating ferromagnetic material and a second layer (2b) made of conductive ferromagnetic material, the first layer (2a) being disposed between the SOT current layer (3) and the second layer (2b).

## Description

### FIELD OF THE INVENTION

The present invention relates to a magneto resistive memory device.

### BACKGROUND OF THE INVENTION

WO2012014131 and WO2012014132 disclose the structure of a memory cell of a so-called SOT magneto resistive memory device and the general architecture of an array of such cells. In the configuration proposed in those documents, a magnetic source external to the memory cell is provided for generating a magnetic bias field to allow deterministic switching of the cell during a write operation. In the magneto resistive memory cell disclosed in WO2012056348, this bias field is not necessary.

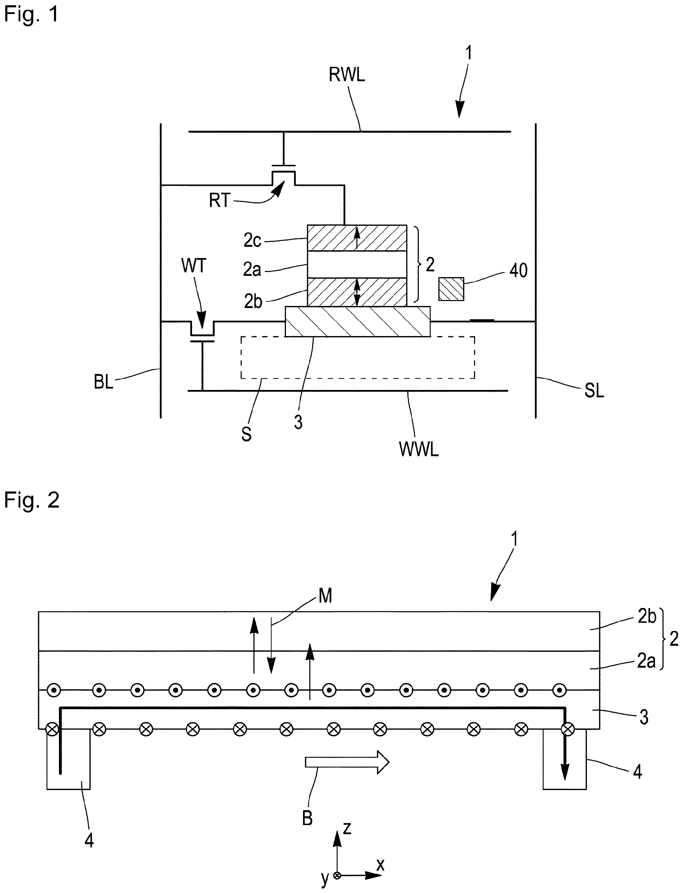

Figure 1 shows an example of a memory cell according to the general principle disclosed by these documents. The memory cell 10 is disposed on a substrate S that defines a main plane. The memory cell 10 includes a magnetic tunnel junction structure 20 that includes a thin dielectric layer 20a sandwiched between a ferromagnetic free layer 20b and a ferromagnetic pinned layer 20c. The dielectric layer 20a forms a tunnel barrier layer between the pinned layer 20c and the free layer 20b. The orientation of the magnetization of the ferromagnetic pinned layer 20c is fixed, perpendicular to the substrate S main plane in this example. The magnetization orientation of the free layer 20b is switchable in the perpendicular axis into one of a parallel state or an antiparallel state with respect to the magnetization orientation of the pinned layer 20c. The free layer 20b may comprise material selected in the list constituted of Fe, Co, Ni, FeCo, CoNi, CoFeB, FeB, FePt, FePd or other suitable ferromagnetic material. The pinned layer 20c may comprise materials selected in the list constituted of Fe, Co, Ni, FeCo, CoNi, CoFEB, FeB, FePt, FePd or other suitable ferromagnetic material. Finally, the dielectric layer 20a may comprise MgO, Al2O3 or other suitable dielectric materials.

The resistance value between the pinned layer 20c and the free layer 20b is dependent on the actual state of the free layer magnetization orientation. When the free layer 20b and the pinned layer 20c have parallel magnetizations, the magnetic tunnel junction presents a relatively lower electric resistance, whereas in the antiparallel magnetizations the magnetic tunnel junction 20 presents a relatively higher electric resistance. The switchable relative magnetization orientation of the free layer 20b defines therefore two states of the memory cell 10, to respectively represent the "0" and "1" values of a bit of information.

The memory cell 10 of figure 1 also comprises a SOT current layer 30 disposed in the main plane of the substrate S, and on which resides the magnetic tunnel junction 20. The free layer 20b of the junction 20 is electrically coupled to the SOT current layer 30, for instance the free layer 20b may be in direct contact with a first face of the SOT current layer 30. The SOT current layer 30 is made of conductive heavy metal layer such has Ta, W, Pt, Cu, Au or other suitable metal materials.

As described in the first two cited documents, the memory device also includes a magnetic source 40 providing a magnetic bias field extending to the magnetic tunnel junction 20. The magnetic bias field (whose amplitude is typically between 100 Oe to 1500 Oe) allows the deterministic switching of the free layer magnetization when a write current is flowing in the SOT current layer 30. It is important to control the amplitude and homogeneity of this field in the free layer 20b, such that an intended state, "0" or "1", may be reliably stored into a junction 20.

In a read operation, a signal from a read word line RWL, turns on a read transistor RT to flow a read current between a bit line BL and a source line SL through the magnetic tunnel junction 20. By sensing the read current, it is possible to identify electric resistance of the magnetic tunnel junction 20, which is dependent on the relative orientation of the magnetization of the pinned layer 20c and of the free layer 20b as mentioned above, and hence of the state store in the memory cell 1.

In a write operation, a signal from a write word line WWL turns on a first write transistor WT to flow a write current between the bit line BL and the source line SL in a write path including the SOT current layer 30 of the selected memory cell 10. The current flowing in the SOT current layer 30 generates a spin-orbit torque originating from a spin Hall effect and/or a Rashba effect that aims at changing the magnetization orientation of the free layer 20b. It is possible to write the magnetic tunnel junction 20 in one configuration by passing a current in one direction (for instance from the bit line BL to the source line SL) and by reversing the current direction (for instance from the source line SL to the bit line BL) it is possible to write the magnetic tunnel junction 20 in the other configuration.

To provide a functional magneto resistive memory device, a large number of the memory cell 10 represented on figure 1 are provided in rows and columns on the substrate S. Bit lines BL and sources lines SL are arranged along respective columns of memory cells 10; read word lines RWL and write word lines WWL are arranged along respective rows of memory cells 10. As this is conventional in a random access memory, a row of memory cells 10 may be collectively written, by activating the corresponding word line WL, after the bit lines BL and sources lines SL have been precharged such that the writing current flows in the direction allowing to set the target state of the memory cell 10.

### OBJECT OF THE INVENTION

The large-scale integration of such a SOT magneto resistive memory device requires improvements to the architecture proposed in the state of the art just outlined above. In general terms, the object of the present invention is to propose an alternative magneto resistive memory cell architecture. This alternative architecture provides, for a given write current, an efficient spin orbit torque effect of the free layer. Also, this architecture may allow to define separate write and read current paths that may simplify the integration of the cell in the memory device.

### SUMMARY OF THE INVENTION

To this effect, the invention relates to a magneto resistive memory cell comprising:
- a SOT current layer defining a main plane;
- a magnetic free layer disposed on the SOT current layer, the magnetization direction of the free layer defining a state of the memory cell.

According to the invention the free layer comprises a first layer made of insulating ferromagnetic material and a second layer made of conductive ferromagnetic material, the first layer being disposed between the SOT current layer and the second layer.

The presence of the first layer made of insulating ferromagnetic material allows to concentrate the current in the SOT current layer at the interface with the first layer made of insulating ferromagnetic material. The spin orbit torque exerted on the free layer is therefore increased, for a given write current, compared to an architecture that does not present the insulating first layer. In other terms, the proposed cell exhibits a high spin-charge conversion efficiency.

Also, the presence of the insulating first layer in the stack defining the memory cell allows to define independent write and read paths, the write current flowing in a write path confined in the SOT current layer and the read current flowing in a separated read path defined in the second layer of the ferromagnetic free layer.

According to further non-limitative features of the invention, either taken alone or in any technically feasible combination:
- the SOT current layer is made of a heavy metal or is comprising one or more material selected from the list formed of Ta, Bi, Pt, W, Ir, Ru, Pd, Cu, Au, Bi, Hf, Se, Sb;
- the SOT current layer is a topological insulator;
- the magneto resistive memory cell further comprises at least two conductive write pads in contact with the SOT current layer to flow a write current along a main direction extending in the SOT current layer between the two conductive write pads;
- the magneto resistive memory cell further comprises an external magnet to provide a bias field, the bias field presenting a component along the main direction;
- the SOT current layer (3) presents broken symmetry properties.
- the thicknesses of the first layer and of the second layer are each comprised between 0.5 nm and 10 nm, preferably between 1 and 3 nm;
- the magneto resistive memory cell further comprises two conductive read pads in electrical contact with the second layer to flow a read current in the second layer between the two conductive read pads;
- the first layer and the second layer present a magnetization in the main plane and the two conductive read pads are in direct contact with the second layer;
- the magneto resistive memory cell further comprises a ferromagnetic conductive pinned layer on the second layer, and at least one conductive read pad being in electrical contact with the pinned layer;
- the magneto resistive memory cell further comprises a capping layer disposed on the pinned layer, the capping layer being made of antiferromagnetic material, or being a synthetic antiferromagnet multilayer structure, or comprising MgO;
- one conductive read pad is electrically connected to one conductive write pad;
- the magneto resistive memory cell further comprises a conductive nonmagnetic separating layer between, and in contact with, the second layer and the pinned layer ;
- the magneto resistive memory cell further comprises a tunnel dielectric layer between, and in contact with, the second layer and the pinned layer, the second layer, the tunnel dielectric layer and the pinned layer defining a magnetic tunnel junction;
- the pinned layer extends continuously on the second layer from one conductive read pad to the other;
- the pinned layer extends partially on the second layer, under at least one conductive read pad ;
- the magneto resistive memory cell further comprises a conductive interlayer between, and in contact with, the first layer and the second layer;
- the conductive interlayer is made of a magnetic coupling material such as Ru, Ir, W, Ta, Mo;
- the second layer extends partially on the first layer, under at least one conductive read pad.

### FIGURES

Many other features and advantages of the present invention will become apparent from reading the following detailed description, when considered in conjunction with the accompanying drawings, in which:
- Figure 1 represents a SOT magneto resistive memory cell of the prior art ;
- Figure 2 represents a magneto resistive memory cell according to the invention;
- Figures 3a and 3b represens a magneto resistive memory cell according to a first embodiment;
- Figure 4 represents a magneto resistive memory cell according to a second embodiment;
- Figures 5 to 7 represent variations of a magneto resistive memory cell according to a third embodiment.

### DETAILED DESCRIPTION OF SPECIFIC EMBODIMENTS OF THE INVENTION

To keep the representations simple, only the elements relevant to the description of the present invention have been included in the figures. A memory device taking profit of the proposed magneto resistive memory cell may comprise further elements not included into the figures.

### General description of the magneto resistive memory cell

With reference to figure 2, a magneto resistive memory cell 1 comprises a SOT current layer 3 defining a main plane extending along the x and y directions on this figure. By convention, the x direction is defined as the direction of a write path in the SOT current layer 3, as this will be exposed later. The memory cell 1 also comprises a magnetic free layer 2 disposed on the SOT current layer 3. The magnetization direction M of the free layer 2 defines the state of the memory cell 1. This direction may lie in the main plane (x, y) for instance parallel or antiparallel to any direction in this plane. Alternatively, the magnetization direction M of the free layer 2 may be perpendicular to the main plane, parallel or antiparallel to the increasing z direction as this is represented on figure 2.

The magneto resistive memory cell 1 and/or the free layer 2 may present a circular cross-section along the main plane. But, more generally, the free layer 2 may present a cross-section of any shape, such as an elliptical, a square or a rectangular shape. Its dimension in the main plane (diameter, major axis, side or length depending on its actual shape) can typically range between 5nm and 1 micron, preferably between 30nm and 60nm.

According to the invention, the magnetic memory cell 1 comprises a first layer 2a made of insulating ferromagnetic material and a second layer 2b made of conductive ferromagnetic material. The first layer 2a is disposed between the SOT current layer 3 and the second layer 2b. For instance, the first layer 2a may be made of, or may comprise, at least one element selected in the list formed of EuS, EuO, YIG, TmIG or GaMnAs. The second layer 2b may be made of, or may comprise, at least one element selected in the list formed of FePt, FePd, CoPt, a rare earth/transition metal alloy, such as GdCo, TdFeCo, Co, Fe, CoFe, Ni, CoNi, CoFeB, FeB, magnetic Heusler alloys such as CoFeAlSi, Co2FeSi, CoFeCrAl, Co2MnSi. The thickness of each of the first layer 2a and of the second layer 2b comprises at least one monolayer (i.e. a layer of one molecule thick) of the material they are formed of. Typically, the thickness of each of these layers 2a, 2b lies between 0.3 nm and 10 nm, and preferably between 1 and 3 nm.

As described in the introduction of this document, the SOT current layer 3 is contacting on its first face the free layer 2, such that a write current flowing into the SOT current layer 3 generates spin polarized charges from a spin Hall effect and/or a Rashba effect. A part of those spin polarized charges is confined at the interface between the SOT current layer 3 and the insulating first layer 2a. The accumulated spin polarized charges at this interface is provoking the generation of a spin current in the free layer 2, along the direction z perpendicular to the main plane, that creates a spin orbit torque able to affect the magnetization orientation M of the free layer 2. The SOT current layer 3 can be in direct contact with the free layer 2 or, alternatively, a thin insulating seed layer (for instance of MgO) can be provided between the current layer 3 and the free ferromagnetic layer 2.

The SOT current layer 3 may reside on a substrate and present any shape, for instance a rectangular, ellipsoidal or circular shape. Its main dimension (length, main axis, diameter depending on the exact shape of this layer) is sufficient to support entirely the free layer 2. The shape and dimensions of the SOT current layer 3 may correspond exactly to the shape and dimension of the free layer 2, as this is represented on figure 2, but the dimension of the SOT current layer 3 may also be greater than the dimension of the free layer 2 and presenting a different shape than the one of the free layer 2. The SOT current layer 3 presents a thickness that may range between 0.5 nm and 200 nm, more particularly between 0.5 nm and 100 nm, or less than 10 nm. Preferably, the SOT current layer 3 has thickness lying in the range 0.5 nm to 5 nm.

To flow a write current in the SOT current layer 3, the magneto resistive memory cell 1 comprises a plurality of conductive write pads 4 in contact with the SOT current layer 3. The conductive write pads 4 are disposed along the main direction such that the write current may flow from one pad to the other in the SOT current layer 3, along the main direction. On the figure 2, the write pads 4 are formed of vias buried in the substrate to connect the cell 1 to another part of the memory circuit. The conductive write pads 4 may take other forms than the vias of figure 2, and they may comprise any conductive interconnects to guide the write current to the SOT current layer 3.

According to an embodiment, the SOT current layer 3 may be made of a conductive heavy metal. More generally, the SOT current layer 3 can include Ta, Bi, Pt, W, Ir, Ru, Pd, Cu, Au, Bi, Hf, Se, Sb or of an alloy of these elements.

According to a preferred embodiment, the SOT current layer 3 may also be made of, or may comprise, a topological insulator such as, for instance, CdTe, HgTe, CdTe, AiSb InAs, GaSb, AlSb, Bi₁₋ₓSbₓ, Sb, Bi₂Se₃, Bi₂Te₃, Cb₂Te₃, Bi₂Te₂Se, (Bi, Sb)₂Te₃, Bi₂₋ₓSbₓTe_{3-y}Se_{y}, Bi₂Te_{1.6}S_{1.4}, Bi_{1.1}Sb_{0.9}Te₂S, Sb₂Te₂Se, Bi₂(Te,Se)₂(Se,S), TlBiSe₂, TlBiTe₂, TlBi(S,Se)₂, PbBi₂Te₄, PbSb₂Te₄, GeBi₂Te₄, PbBi₄Te₇, GeBi₄₋ₓSbₓTe₇, (PbSe)₅(Bi₂Se₃)₆, (Bi₂)(Bi₂Se_{2.6}S_{0.4}), (Bi₂)(Bi₂Te₃)₂, SnTe, Pb₁₋ₓSnₓTe, Pb_{0.77}Sn_{0.12}Se, Bi bilayer, Ag₂Te, SmB₆, Bi₁₄Rh₃I₉, RBiPt (R=Lu, Dy, Gd,), Nd₂(Ir₁₋ₓRhₓ)₂O₇, WTe₂, MoTe₂, TaAs, HgTe, Y₂Ir₂O₇, HgCr₂Se, Hg_{1-x-y}CdₓMnyTe, TaP, NbAs, NbP, Na₃Bi, Cd₃As₂, ZrTe₅, Na₃Bi, Cd₃As₂, WₓMo₁₋ₓTe₂, LnPtBi, GdPtBi, NdPtBi, XCO₂Z (X=V, Zr, Nb, Ti, Hf, Z=Si, Ge, Sn), KHgSb, CuMnAs, Mn₃Sn, Mn₃Ge, ZrSiS, LaAlGe. As a reminder, a layer made of topological insulator behave as an insulator in its interior (i.e. presenting a conductivity in its bulk that is zero or close to zero) but its surfaces contain conducting states, such that charges can only move along the surface of the layer. In the heterostructure of figure 2 where a SOT current layer 3, made of a topological insulator, is contacting an insulating ferromagnetic first layer 2a, a current flowing on the topological insulator surfaces can lead to a non-equilibrium surface spin accumulation at the interface between the two layers as well as a spin current flowing in a direction perpendicular to the main plane. The spin current and the spin accumulation couple to the adjacent free layer 2 and exert a torque resulting in the switching of the polarization of the free layer 2.

When the magnetization direction of the free layer 2 lies in the main plane, parallel or antiparallel to the increasing x direction, the writing and storage in the free layer 2 may be achieved without a magnetic bias field B. If, as this is represented on figure 2, the magnetization direction of the free layer 2 is perpendicular to the main plane, the effective writing and storage requires to break the symmetrical behavior of the system, to favor the switching of the polarization of the free layer into a definite state depending on the direction of the write current. To break such a symmetry, an external magnet providing a bias field is usually provided, but this is not the only possible solution. In particular, this layer 3 may present broken symmetry properties such that there is no need for an external magnet to provide a bias field. On the representation of figure 2, the magneto resistive memory cell 1 is provided with an external magnet configured to provide a bias field B presenting a component along the main direction (i.e. the x direction). For instance, in the presence of a bias magnetic field having a component in the x direction, the z-component magnetization of the free layer 2 can be switched reliably by changing the current direction. Preferably, the magnetic bias field is oriented entirely along the main direction.

The magneto resistive memory cell 1 of figure 2 may also comprise further layers, for instance layers residing on the free layer 2 of the cell, as this will be described in greater details with reference to the various examples and embodiments that follows. But whether or not such further layers are present, the cell 1 comprises at least two conductive read pads in electrical contact with the second layer 2b of the free layer 2. The conductive read pads are disposed on the second layer 2b, such that a read current is able to flow in the second layer 2b between the two conductive read pads. The read current allows to sense the state stored into the free layer 2.

### Embodiment 1

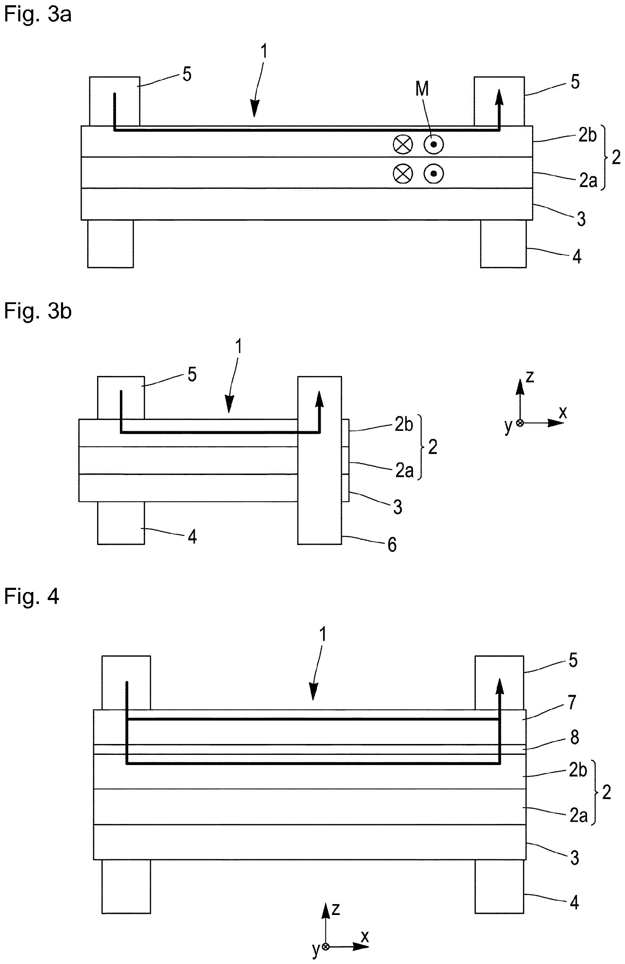

In the first embodiment represented on figures 3a, and 3b, the first layer 2a and the second layer 2b (the free layer 2) present a magnetization M in the main plane (x, y). The magnetization M presents a component along the direction y, perpendicular to the main direction x, and a component along the direction x. The conductive read pads 5 (here two vias) are in direct contact with the second layer 2b, and a read current injected in the second layer 2b is confined in this layer thanks to the presence of the insulating first layer 2a. Determination of the actual direction of the magnetization during a reading operation of the memory cell 1 is performed by exploiting the anisotropic magnetoresistance of the second layer 2b. Anisotropic magnetoresistance is the property of certain materials to present an electrical resistance depending on the angle formed between the current flow and the orientation of a magnetic field. Maximum resistance is usually observed when the direction of the current is parallel to the magnetic field, and minimum resistance when the direction of the current is antiparallel to the magnetic field. To read the state stored in the memory cell 1, i.e. the magnetization direction M of the second layer 2b, a read current is injected in the second layer 2b for instance along the increasing x direction on the figure 3a, from a first the read contact pad to a second read contact pad. A read circuit of the memory device then determines the resistance of the read path, and establishes the actual state stored in the second layer 2b by comparing the resistance to a predetermined threshold.

In the example of figure 3b of this first embodiment, one conductive read pad 5 is electrically connected to one conductive write pad 4, to form a single contact pad 6. This contact pad 6 is forming a via through the SOT current layer 3 and free layer 2, and is used both for flowing a write current and a read current. Additional circuit of the memory device selectively connects the single contact pad 6 to the read and to the write circuit, depending on the operation to be performed.

### Embodiment 2

In the second embodiment represented on figure 4, the magneto resistive memory cell 1 comprises a ferromagnetic conductive pinned layer 7 disposed on the second layer 2b. The pinned layer 7 presents a fixed magnetization and may be made of a material selected in the list formed of FePt, FePd, CoPt, a rare earth/transition metal alloy, such as GdCo, TdFeCo, Co, Fe, CoFe, Ni, CoNi, CoFeB, FeB; and may present a thickness comprised between 0.5 nm and 10 nm, preferably between 1 and 3 nm. In this second embodiment, a conductive nonmagnetic separating layer 8 is disposed between, and in contact with, the second layer 2b and the pinned layer 7. The separating layer 8 may be formed of nonmagnetic material such as Cr, Cu, Al, Ti, V. Its thickness may be comprised between 0.5 nm and 5 nm. The conductive read pads 5 are in electrical contact with the pinned layer 7, and a read current injected through one of the read pads 5 flows in parallel path in the pinned layer 7 and in the second layer 2b.

Determination of the actual direction of the magnetization during a reading operation of the memory cell 1 is performed by exploiting the giant magnetoresistance effect in the second layer 2b and in the pinned layer 7. According to this effect, a significant change of the electrical resistance in the read path is observed depending on whether the magnetization of the two adjacent ferromagnetic layers 2b, 7 are in a parallel or an antiparallel alignment. The reading of the state stored in the free layer 2 can be done by passing a read current through the two conductive read pads 5. A part of the read current will flow inside the second layer 2b. If the pinned layer 7 and the second layer 2b have the same magnetization the resistance is lower. If the magnetization of the two layers 7, 2b are in opposite direction then the resistance is higher. It is then possible to differentiate the two states.

In this second embodiment, the free layer 2 and the pinned layer 7 may present a magnetization indifferently oriented both in the main plane or both oriented perpendicular to the main plane. The magnetization of the pinned layer 7 is fixed.

The in-plane orientation of the magnetization may be achieved by the shape anisotropy, crystalline anisotropy, or magnetoelastin anisotropy of the free layer 2 creating the magnetization easy axis in the plane of this layer. Alternatively, the magnetization in the plane of the free layer 2 may be provoked by the presence of a capping layer disposed on the pinned layer 7, the capping layer being made of antiferromagnetic material, such as PtMn or IrMn, or being a synthetic antiferromagnet multilayer structure.

The perpendicular orientation of the magnetization may be achieved by selecting the nature of the pinned layer 7, for instance by having a pinned layer made of Co/Ni or Co/Pt multilayer. Alternatively, the perpendicular orientation of the magnetization may be provoked by the presence of a capping layer made for instance of MgO and disposed on the pinned layer 7.

As in the first embodiment, a single contact pad, for example the same via as the one represented in figure 2b, may replace one conductive read pad 5 and one conductive write pad 4 to provide, in this second embodiment, a three terminal memory cell 1.

### Embodiment 3

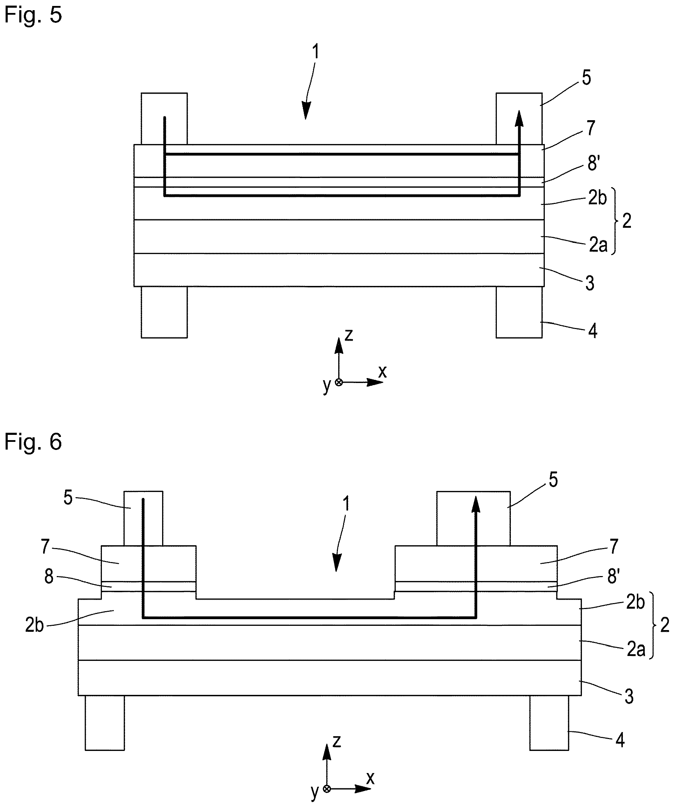

The third embodiment represented on figure 5 also comprises a pinned layer 7 disposed on the second layer 2b of the free layer 2. The second layer 2b and the pinned layer 7 are separated by, and each in contact with, a tunnel barrier 8' of a few nanometers thick. The tunnel barrier 8' may comprise MgO, Al2O3 or other suitable dielectric materials. The second layer 2b, the tunnel barrier 8' and the pinned layer 7 are defining together a magnetic tunnel junction.

As this is well known in the art, charges can flow through the tunnel barrier. If the magnetizations of the free layer 2 and of the pinned layer 7 are in a parallel orientation it is more likely that charges will cross through the tunnel barrier 8' than if they are in the antiparallel orientation. Consequently, the junction can be switched between two states of electrical resistance, one with low and one with high resistance. Determination of the actual direction of the magnetization during a reading operation of the memory cell 1 is performed by exploiting this tunnel magnetoresistance effect. The reading of the state stored in the free layer 2 can be done by passing a read current through the two conductive read pads 5. A part of the read current will flow inside the second layer 2b. If the pinned layer 7 and the free layer 2 have the same magnetization, the resistance is lower. If the magnetization of the two layers 7, 2b are in opposite direction then the resistance is higher.

As in the first embodiment, a single contact pad, for example the same via as the one represented in figure 3b, may replace one conductive read pad 5 and one conductive write pad 4 to provide, in this third embodiment, a three terminal memory cell 1.

It is possible in this third embodiment to differentiate the two states, but since the pinned layer 7 extends continuously on the second layer 2b, the current flowing in this layer 7 from one conductive read pad to the other, in parallel to the current flowing in the second layer 2b, is not contributing to this differentiation. The configuration of figure 6 is improving this situation. In this configuration, the pinned layer 7 extends partially on the second layer 2b, under at least one conductive read pad 5. Consequently, no current can flow in the pinned layer 7 from one conductive read pad 5 to the other, short-circuiting the useful read current flowing in the second layer 2b of the free layer 2.

In the representation of the cell 1 of figure 6 the resistance measured during a read operation is equivalent to two magnetic tunnels junctions in series. The width of the pillars forming the magnetic tunnels junctions (in the x and y directions) can be the identical or different and their shapes may be of any type, for instance circular, rectangular, or elliptical. In addition, the fabrication of this configuration is particularly simple because the SOT current layer 3, the first and second layers 2a, 2b, the tunnel barrier 8' and the pinned layer 7 may be deposited full plate, and then tunnel barrier 8' and pinned layer 7 may be selectively removed, for instance by etching, the free layer 2 being used as an etch stop. It is not necessary to preserve the pinned layer 7 and the tunnel barrier 8' under both conductive read pads 5, and in a variation of the example of figure 6, only one magnetic tunnels junction is formed under one conductive read pad 5, the second conductive read pad 5 being directly in contact with the second layer 2b.

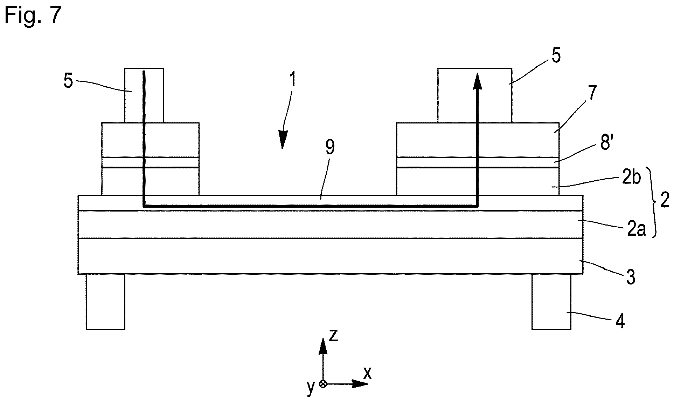

Figure 7 represents another variation of this third embodiment. In this variation to the example of figure 6, the second layer 2b layer extends partially on the first layer 2a, under at least one conductive read pad 5. Consequently, two pillars forming magnetic tunnels junctions are residing on the first layer 2a of the free layer 2. To propagate the read current from one conductive read pad 5 to the other (the first layer 2a being insulating), a conductive interlayer 9 is disposed between, and in contact with, the first layer 2a and the remaining portion of the second layer 2b. The conductive interlayer may be made of a magnetic coupling material such as Ru, Ir, W, Ta, Mo.

Other variations to the disclosed embodiments can be understood and effected by those skilled in the art in practicing the claimed invention, from a study of the drawings, the disclosure, and the appended claims.

In particular, in all presented embodiments, the stack of layers may be reversed, i.e. by having the SOT current layer 3 on top of the free layer 2.

The memory device described in the various embodiments of this disclosure may be manufactured using conventional deposition steps and photolithographic steps to successively elaborate the various layers and patterns forming the stacks represented in the figures. The substrate onto which the stack of material is formed usually comprises part of the electronic circuits of and metallization's levels necessary to make the overall device functional.

## Claims

1. A magneto resistive memory cell (1) comprising:
• a SOT current layer (3) defining a main plane;
• a magnetic free layer (2) disposed on the SOT current layer (3), the magnetization direction (M) of the free layer (2) defining a state of the memory cell (1);
the magnetic memory cell (1) being **characterized in that** the free layer (2) comprises a first layer (2a) made of insulating ferromagnetic material and a second layer (2b) made of conductive ferromagnetic material, the first layer (2a) being disposed between the SOT current layer (3) and the second layer (2b) .

2. The magneto resistive memory cell (1) of claim 1 wherein the SOT current layer (3) is made of a heavy metal or is comprising one or more material selected from the list formed of Ta, Bi, Pt, W, Ir, Ru, Pd, Cu, Au, Bi, Hf, Se, Sb.

3. The magneto resistive memory cell (1) of claim 1 wherein the SOT current layer (3) is a topological insulator.

4. The magneto resistive memory cell (1) of any preceding claims further comprising at least two conductive write pads (4) in contact with the SOT current layer (3) to flow a write current along a main direction extending in the SOT current layer (3) between the two conductive write pads (4).

5. The magneto resistive memory cell (1) according to any preceding claims further comprising two conductive read pads (5) in electrical contact with the second layer (2b) to flow a read current in the second layer (2b) between the two conductive read pads (5).

6. The magneto resistive memory cell (1) according to the preceding claim wherein the first layer (2a) and the second layer (2b) present a magnetization in the main plane and the two conductive read pads (5) are in direct contact with the second layer (2b).

7. The magneto resistive memory cell (1) according to claim 5 comprising a ferromagnetic conductive pinned layer (7) on the second layer (2b), and wherein at least one conductive read pad (5) is in electrical contact with the pinned layer (7) .

8. The magneto resistive memory cell (1) according to claim 7 further comprising a capping layer disposed on the pinned layer (7), the capping layer being made of antiferromagnetic material, or being a synthetic antiferromagnet multilayer structure, or comprising MgO.

9. The magneto resistive memory cell (1) according to any of claims 7 and 8 further comprising a conductive nonmagnetic separating (8) layer between, and in contact with, the second layer (2b) and the pinned layer (7).

10. The magneto resistive memory cell (1) according to any of claims 7 and 8, further comprising a tunnel dielectric layer (8') between, and in contact with, the second layer (2b) and the pinned layer (7), the second layer (2b), the tunnel dielectric layer (8') and the pinned layer (7) defining a magnetic tunnel junction.

11. The magneto resistive memory cell (1) according to the preceding claim wherein the pinned layer (7) extends continuously on the second layer (2b) from one conductive read pad (5) to the other.

12. The magneto resistive memory cell (1) according to claim 10, wherein the pinned layer (7) extends partially on the second layer (2b), under at least one conductive read pad (5) .

13. The magneto resistive memory cell (1) according to the preceding claim, further comprising a conductive interlayer (9) between, and in contact with, the first layer (2a) and the second layer (2b).

14. The magneto resistive memory cell (1) according to the preceding claim 13, wherein the second layer (2b) layer extends partially on the first layer (2a), under at least one conductive read pad (5).

15. The magneto resistive memory cell (1) according to claim 4 combined with any of claims 5 to 14 wherein one conductive read pad (5) is electrically connected to one conductive write pad (4).
